(19) Europäisches Patentamt / European Patent Office / Office européen des brevets

(11) **EP 2 485 269 A1**

(12) **EUROPEAN PATENT APPLICATION**
published in accordance with Art. 153(4) EPC

(43) Date of publication:
   **08.08.2012 Bulletin 2012/32**

(51) Int Cl.:
   **H01L 31/042** (2006.01)

(21) Application number: **10820400.9**

(22) Date of filing: **21.09.2010**

(86) International application number:
   **PCT/JP2010/066300**

(87) International publication number:
   **WO 2011/040281 (07.04.2011 Gazette 2011/14)**

(84) Designated Contracting States:
   **AL AT BE BG CH CY CZ DE DK EE ES FI FR GB GR HR HU IE IS IT LI LT LU LV MC MK MT NL NO PL PT RO SE SI SK SM TR**

(30) Priority: **29.09.2009 JP 2009223906**

(71) Applicant: **Toppan Printing Co., Ltd.**
   **Tokyo 110-0016 (JP)**

(72) Inventors:
   • **MATSUSHIMA Atsushi**
      **Tokyo 110-0016 (JP)**
   • **FURUYA Takeshi**
      **Tokyo 110-0016 (JP)**
   • **HIRATA Tatsu**
      **Tokyo 110-0016 (JP)**
   • **NISHIZAWA Tomo**
      **Tokyo 110-0016 (JP)**

(74) Representative: **Martin, Philip John**
   **Marks & Clerk LLP**
   **62-68 Hills Road**
   **Cambridge**
   **CB2 1LA (GB)**

(54) **SEALING MATERIAL SHEET**

(57) A sealing material sheet is provided which can reduce an amount of air infiltrated into a laminate in the step of laminating constituent members of a solar cell module and can shorten the time necessary for the heating and degassing process in a vacuum in the solar cell module manufacturing process. The sealing material sheet is used as a member of a solar cell module formed by heating and pressing a laminate in which a first protective member 5, a first sealing material sheet 6, a photoelectric conversion cell 7, a second sealing material sheet 8, and a second protective member 9 are laminated in this order, an uneven pattern is formed on one surface or both surfaces of the first sealing material sheet 6 and the second sealing material sheet 8 through an embossing process, and the embossing process is performed so that the porosity of the first sealing material sheet 6 and the second sealing material sheet 8 is in the range of 1% to 4%.

FIG. 3

EP 2 485 269 A1

**Description**

TECHNICAL FIELD

The present invention relates to a sealing material sheet used in the process of manufacturing a solar cell module. Priority is claimed on Japanese Patent Application No. 2009-223906, filed September 29, 2009, the content of which is incorporated herein by reference.

BACKGROUND ART

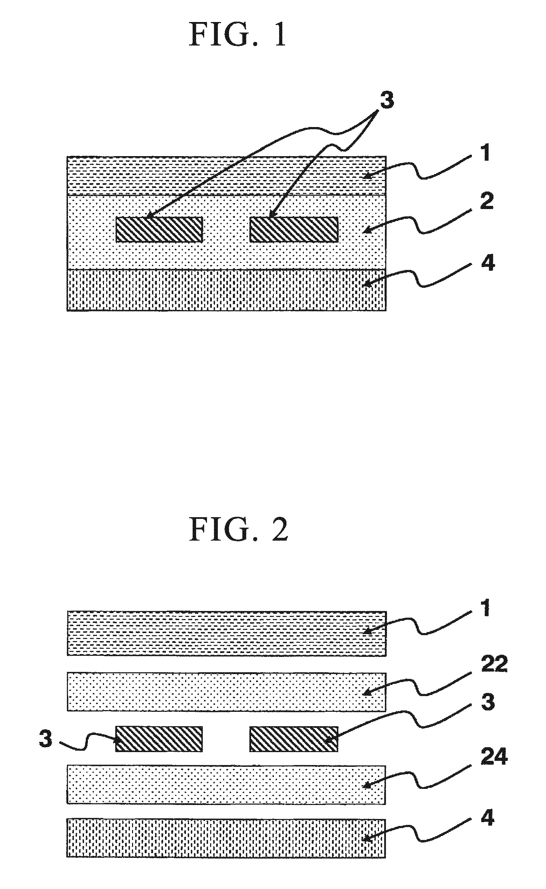

Solar cells have attracted attention as a clean power generation source using solar light. In a general solar cell module, as shown in FIG. 1, solar cells 3 are disposed in a sealing layer 2 and the outsides thereof are protected with a front-side protective member 1 and a back-side protective member 4.
To manufacture a solar cell module, as shown in FIG. 2, a laminate in which constituent members are laminated in the order of a front-side protective member 1, a sealing material sheet 22, solar cells 3, a sealing material sheet 24, and a back-side protective member 4 is heated and degassed in a vacuum, is then heated in a vacuum with an application of a load of 1 atm, the sealing resin is cross-linked and hardened, and the resultant members are bonded into a body.
Regarding the materials of the sealing material sheets 22 and 24, EVA (Ethylene-Vinyl Acetate copolymer) is often used as a main resin thereof. For the purpose of providing various functions such as close adhesion, weather resistance, and light resistance, additives such as a cross-linking agent, an auxiliary cross-linking agent, a silane-coupling agent, a stabilizer, an ultraviolet absorber, an anti-aging agent, and a discoloration-preventing agent are often included therein at a constant ratio.
The method of producing the sealing material sheet employs a "T-die method of extruding a molten resin from a die having a linear slit and rapidly cooling and solidifying the resultant with a cooling roll or a water tank" or a "calender method". A seal sheet with a thickness of about 500 μm is formed through the use of these film-forming processes. In the film-forming processes, the surface of the sealing material sheet may be subjected to an embossing process to provide unevenness thereto.
Methods of manufacturing a solar cell module are disclosed in Patent Documents 1 and 2.

PRIOR ART DOCUMENTS

PATENT DOCUMENTS

Patent Document 1: Japanese Patent No. 3473605
Patent Document 2: Japanese Patent No. 3174531

DISCLOSURE OF INVENTION

PROBLEMS TO BE SOLVED BY THE INVENTION

In manufacturing a solar cell module hitherto, since the sealing material sheet is pressed by solar cells during heating and pressing in the sealing process, there is a problem in that the solar cells may be destroyed from the pressing force. There is also a problem in that air infiltrates due to degassing failure during the sealing and bubbles remain in the module, thereby lowering the production yield. To solve these problems, cushioning properties and degassing properties in the heating and pressing processes have been improved through the use of an embossing process to provide unevenness to the surface of the sealing material sheet or techniques of forming through-holes in the sealing material sheet (see Patent Documents 1 and 2).
Particularly, regarding the embossing process, when the embossing is performed so that the percentage $V_H/V_A \times 100$ % (hereinafter, referred to as porosity P) of the total volume $V_H$ of the concave portions per unit area of the sealing material sheet and the apparent volume $V_A$ of the sealing material sheet obtained by multiplying the unit area by the maximum thickness is in the range of 5% to 80% (preferably in the range of 20% to 50%), it is considered that the cushioning properties and the degassing properties are improved (see Patent Document 1).
However, in the sealing material sheet having been subjected to the deep embossing process with a porosity P of 5% to 80% or the EVA resin sheet having through-holes formed therein, there is a problem in that a predetermined amount of air is already included in the laminate in the step of laminating the constituent members of the solar cell module in the order of the front-side protective member, the sealing material sheet, the solar cells, the sealing material sheet, and the back-side protective member, and thus it takes time to perform the heating and degassing processes in a vacuum. The invention is made to solve the above-mentioned problems.

MEANS FOR SOLVING THE PROBLEMS

According to a first aspect of the invention, there is provided a sealing material sheet which is used as a member of a solar cell module formed by heating and pressing a laminate in which a first protective member, a first sealing material sheet, a photoelectric conversion cell, a second sealing material sheet, and a second protective member are laminated in this order, wherein an uneven pattern is formed on one surface or both surfaces of the first sealing material sheet and the second sealing material sheet through an embossing process, and the embossing process is performed so that the percentage $V_H/V_A \times 100$ % of the total volume $V_H$ of concave portions per unit area of the first sealing material sheet and the second sealing material sheet and the apparent volume $V_A$ of the sealing material sheets obtained by multiplying the unit area by the maximum thickness is in the range of 1% to 4%.
According to a second aspect of the invention, in the sealing material sheet according to the first aspect, the minimum value of a storage elastic modulus is equal to or less than $10^4$ Pa when the sealing material sheet with a thickness of 1 mm is interposed between two $\phi$25 mm A1 plates and dynamic viscoelasticity of the sealing material sheet is measured at intervals of 1°C in the course of raising the temperature from a measurement start temperature of 40°C to a measurement end temperature of 150°C with a deformation ratio of 5% and at a frequency of 1 Hz.

EFFECTS OF THE INVENTION

According to the invention, by employing a sealing material sheet with a porosity of 1% to 4%, it is possible to reduce an amount of air infiltrated into a laminate in the step of laminating the constituent members of the solar cell module and to shorten the time necessary for the heating and degassing process in a vacuum in the solar cell module manufacturing process.
The cushioning properties in the heating and pressing process in manufacturing a solar cell module are lowered in comparison with a sealing material sheet with a porosity of 5% to 80% by setting the porosity of the sealing material sheet to the range of 1% to 4%; however, it is possible to compensate for the lowering in cushioning properties and to prevent the solar cell from cracking in the heating and pressing process, by selecting a resin with a low elastic modulus as a resin which is a main material of the sealing material sheet. Since the fluidity of the resin in the heating and degassing process in a vacuum increases, it is possible to improve the degassing efficiency.
Accordingly, it is possible to shorten the time necessary for the heating and degassing process and to improve the manufacturing efficiency of the solar cell module.

BRIEF DESCRIPTION OF DRAWINGS

FIG. 1 is a diagram illustrating a layer structure of a solar cell module in the background art.
FIG. 2 is a diagram illustrating a method of manufacturing a solar cell module in the background art.
FIG. 3 is an exploded sectional view of a solar cell module employing a sealing material sheet according to the invention.
FIG. 4 is a diagram illustrating the constituent members and the configuration of a pseudo solar cell module manufactured according to an example and the heating and pressing processes.
FIG. 5 is a diagram illustrating positions at which samples (EVA resin films) for measurement of porosity are cut out from an EVA resin roll.
FIG. 6 is a diagram illustrating positions at which five sample pieces for measurement of the maximum thickness are cut out from an EVA resin film.

EMBODIMENTS FOR CARRYING OUT THE INVENTION

Hereinafter, embodiments of the invention will be described in detail. In the embodiments, like elements are referenced by like reference signs and description thereof will not be repeated.

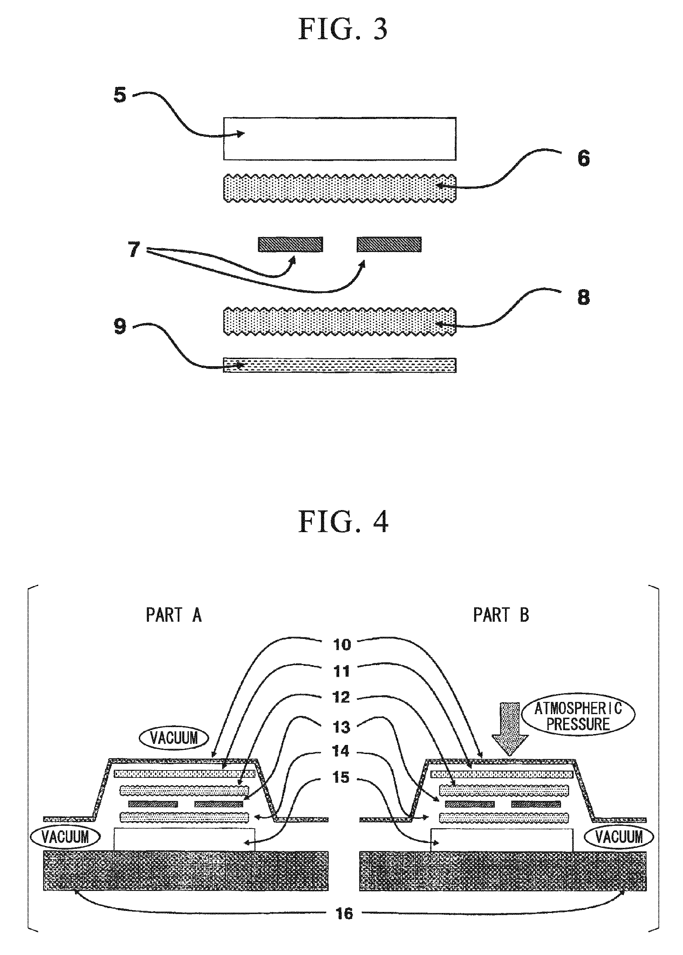

FIG. 3 is an exploded sectional view of a solar cell module employing a sealing material sheet according to the invention.
In FIG. 3, a solar cell module is formed by heating and pressing a laminate in which a first protective member 5, a first sealing material sheet 6, solar cells 7, a second sealing material sheet 8, and a second protective member 9 are laminated in this order. An uneven pattern is formed on one surface or both surfaces of the first sealing material sheet 6 and the second sealing material sheet 7 through the use of an embossing process. The embossing process is performed so that the percentage $V_H/V_A \times 100$ % of the total volume $V_H$ of the concave portions per unit area of the first sealing material sheet 6 and the second sealing material sheet 7 and the apparent volume $V_A$ of the sealing material sheets obtained by multiplying the unit area by the maximum thickness is in the range of 1% to 4%. In the example shown in FIG. 3, the first protective member 5 serves as a front-side protective member and the second protective member 9 serves as a back-side protective member.

Examples of the main material of the first sealing material sheet 6 and the second sealing material sheet 8 include polyolefins such as polyethylene and polypropylene; ionomers; ethylene-vinyl acetate copolymers; polyfluorovinyl; polyvinyl chloride; or copolymers thereof.

A resin having high transparency may be used as the main material of the first sealing material sheet 6 and the second sealing material sheet 8 and ethylene-vinyl acetate or the like can be preferably used.

A cross-linking agent may be added to the first sealing material sheet 6 and the second sealing material sheet 8 without damaging the transparency for the purpose of enhancing the strength. Examples of the cross-linking agent include such as 1,1-di(t-butylperoxy)cyclohexane, 1,1-di(t-hexylperoxy)cyclohexane, n-butyl 4,4-di(t-butylperoxy)valerate, t-butylperoxy-3,5,5-trimethylhexanoate, 2,5-dimethyl-2,5-di(t-butylperoxy)hexane, t-butylcumylperoxide, and 2,2-di(t-butylperoxy)butane.

An additive for promoting a cross-linking reaction in addition to the cross-linking agent may be added to the first sealing material sheet 6 and the second sealing material sheet 8. Examples of the additive include such as triallyl isocyanurate, diallyl phthalate, and triallyl cyanurate.

Other than the above-mentioned, a silane-coupling agent, an ultraviolet absorber, and an anti-oxidant may be also added thereto.

Examples of the silane-coupling agent used to improve the close adhesion include such as γ-methacryloxy propyltrimethoxysilane, trimethoxypropylsilane, trimethoxymethylsilane, vinyltrimethoxysilane, vinyltriethoxysilane, trichloropropylsilane, and triethoxyphenylsilane.

Examples of the ultraviolet absorber used to improve the light resistance include such as 2-(5-methyl-2-hydroxyphenyl)benzotriazole, 2-(3-t-butyl-5-methyl-2-hydroxyphenyl)-5-chlorobenzotriazole, 2-(4,6-diphenyl-1,3,5-triazine 2-yl)-5-[(hexyl)oxy]-phenol, 2,4-dihydroxybenzophenone, and 2-hydroxy-4-n-octyloxybenzophenone.

Examples of the anti-oxidant used to improve the thermal stability include such as 1,6-hexanediol-bis[3-(3,5-di-t-butyl-4-hydroxyphenyl)propionate, pentaerythritol tetrakis[3-(3,5-di-t-butyl-4-hydroxyphenyl)propionate], tris(2,4-di-t-butylphenyl)phosphite, and 2,4-bis-(n-octylthio)-6-(4-hydroxy-3,5-di-t-butylanilino)-1,3,5-triazine.

A film is formed of the resin in which the main material and the additives are mixed, heated, and melted through the use of a T-die method or a calender method to produce a sealing material sheet. By suspending the resin sheet in the thermally-melted state on a roll (formed of metal or rubber) having an uneven pattern formed on the surface thereof in the course of forming the film, the uneven pattern of the roll can be transferred to one surface or both surface of the first sealing material sheet 6 and the second sealing material sheet 8 to form embossing on one surface or both surfaces of the first sealing material sheet 6 and the second sealing material sheet 8.

The uneven pattern of the roll in the course of forming a film is selected to perform the embossing process on the sealing material sheets, so that the porosity P defined as the percentage $V_H/V_A \times 100$ % of the total volume $V_H$ of the concave portions per unit area of the first sealing material sheet 6 and the second sealing material sheet 7 and the apparent volume $V_A$ of the sealing material sheets obtained by multiplying the unit area by the maximum thickness is in the range of 1% to 4%.

The porosity P defined as the percentage $V_H/V_A \times 100$ % can be calculated as follows. That is, in the sealing material sheet having been subjected to the embossing process, the apparent volume $V_A$ (mm$^3$) of the sealing material sheet is the product of the maximum thickness $t_{max}$ (mm) of the sealing material sheet and the unit area (for example, 1 m$^2$=1000x1000=$10^6$ mm$^2$) and is calculated as follows.

$$V_A \ (mm^3) = t_{max} \times 10^6$$

On the other hand, the actual volume $V_0$ (mm$^3$) of the sealing material sheet per unit area is calculated from the specific gravity p (g/mm$^3$) of the resin constituting the sealing material sheet and the actual weight W (g) of the sealing material sheet per unit area (1 m$^2$) as follows.

$$V_0 \ (mm^3) = W/\rho$$

The total volume $V_H$ (mm$^3$) of the concave portions per unit area of the sealing material sheet is a value obtained by subtracting the actual volume $V_0$ from the apparent volume $V_A$ of the sealing material sheet and is calculated as follows.

$$V_H \ (mm^3) = V_A - V_0 = V_A - (W/\rho)$$

Therefore, the porosity (%) can be calculated as follows.

$$Porosity \ P \ (\%) = V_H/V_A \times 100 = (V_A - (W/\rho))/V_A \times 100$$

$$= 1 - W/(\rho \cdot V_A) \times 100 = 1 - W/(\rho \cdot t_{max} \cdot 10^6) \times 100$$

The porosity (%) cannot only be calculated by the use of the above-mentioned expression but can also be obtained by imaging a section or a surface subjected to the embossing process in the actual sealing material sheet through the use of a microscope and performing an image processing.

The maximum thickness $t_{max}$ of the sealing material sheet represents the distance between the tip of the convex portions and the back surface when the embossing process is performed on one surface of the sealing material sheet, and represents the distance (the distance in the film thickness direction) between the tips of the convex portions on both surfaces when the embossing process is performed on both surfaces of the film. The maximum thickness $t_{max}$ is preferably in the range of 50 to 2000 $\mu$m.

As described above, the cushioning properties in the heating and pressing process in manufacturing a solar cell module are lowered in comparison with a sealing material sheet with a porosity of 5% to 80% by setting the porosity of the sealing material sheet to the range of 1% to 4%; however, it is possible to solve such a problem by selecting a resin with a low elastic modulus as the resin which is the main material of the sealing material sheet. In addition, since the fluidity of the resin in the heating and degassing process increases, it is possible to improve the degassing efficiency. The resin with a low elastic modulus is defined as follows.

The minimum value of the storage elastic modulus is equal to or less than $10^4$ Pa when the sealing material sheet with a thickness of 1 mm is interposed between two $\phi$25 mm A1 plates and the dynamic viscoelasticity of the sealing material sheet is measured at intervals of 1°C in the course of raising the temperature from a measurement start temperature of 40°C to a measurement end temperature of 150°C with a deformation ratio of 5% and at a frequency of 1 Hz. The dynamic viscoelasticity can be measured, for example, by the use of Rheometer AR-2000CX made by TA Instruments Ltd. The resin with a low elastic modulus can be obtained by appropriately selecting the resin or appropriately adjusting the kinds and amounts of the additives.

Examples

Hereinafter, the invention will be described in more detail with reference to examples and comparative examples, but the invention is not limited to the examples.

Example 1

An EVA resin of which the minimum value of the storage elastic modulus is 9200 Pa was prepared by adjusting the resin composition and the mixing ratio of the additives. That is, in this EVA resin, the minimum value of a storage elastic modulus is equal to or less than 9200 Pa when the sealing material sheet with a thickness of 1 mm is interposed between two $\phi$25 mm A1 plates and dynamic viscoelasticity of the sealing material sheet is measured at intervals of 1°C in the course of raising the temperature from a measurement start temperature of 40°C to a measurement end temperature of 150°C with a deformation ratio of 5% and at a frequency of 1 Hz. An EVA resin roll of which both surfaces have been subjected to the embossing process so that the porosity is in the range of 3% to 4% was produced using the EVA resin.

A pseudo solar cell module was manufactured by way of a trial using a sealing material sheet cut out from the EVA resin roll and the degassing performance of the sealing material sheet was checked. The trial manufacturing process of the pseudo solar cell module and the method of checking the degassing performance will be described below.

The trial manufacturing conditions of the pseudo solar cell module will be described below with reference to FIG. 4. As shown in Part A of FIG. 4, a laminate, in which a back sheet (the back-side protective member 11) of 290 mmx210 mm, a sealing material sheet 12 of 280 mm×200 mm, solar cells 13, a sealing material sheet 14 of 280 mm×200 mm, and a reinforced glass (the front-side protective member 15) with a size of 290 mm×210 mm and a thickness of 3 mm were sequentially laminated, was disposed in a laminating machine in which the inside of an upper cover and the inside of a laminating chamber (the space surrounded with a laminating upper cover 10 and a laminating bottom 16) can be vacuum-drawn. The vacuum drawing was performed on both the inside of the upper cover and the inside of the laminating chamber for 90 seconds while maintaining the temperature of the laminating chamber at 150°C. And the laminate was temporarily pressed while degassing the inside of the laminate (Part A of FIG. 4, vacuum degassing and temporary pressing process). For the purpose of checking the degassing properties when the time necessary for the vacuum degassing and temporary pressing process, a laminate in which the same materials as described above were laminated in the same order was temporarily pressed while being degassed for 60 seconds.

After the temporary pressing process, the temperature of the laminating chamber was set to 150°C, the vacuum of the laminating upper cover was released, and the laminate was thermally pressed under atmospheric pressure for 10 minutes (Part B of FIG. 4, a main pressing process).

Regarding the appearance of the pseudo solar cell module having been subjected to the main pressing process, it was checked with visual observation whether bubbles of 1 $mm^2$ or more remained therein.

In this example, the manufacture of the pseudo module and the checking of bubbles with visual observation were repeated 30 times, respectively, when the time of the vacuum degassing and temporary pressing process was set to 60 seconds and when the time is set to 90 seconds. The results for the checking of the bubbles with visual observation in this example are shown in Table 1.

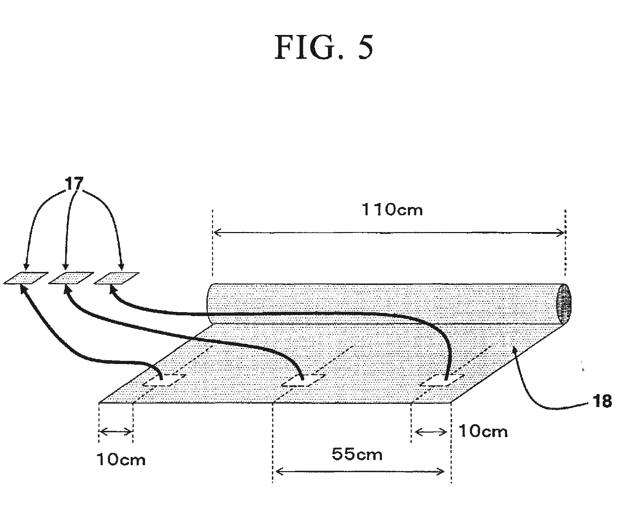

As shown in FIG. 5, the values of the porosity P described in this example are measured values obtained by cutting out a square EVA resin film 17 with a size of 10 cm×10 cm from both ends (parts separated by 10 cm in the width direction from the roll ends) of the EVA resin roll 18 with a width of 110 cm and the center of the roll and measuring the porosity using the films 17 as samples.

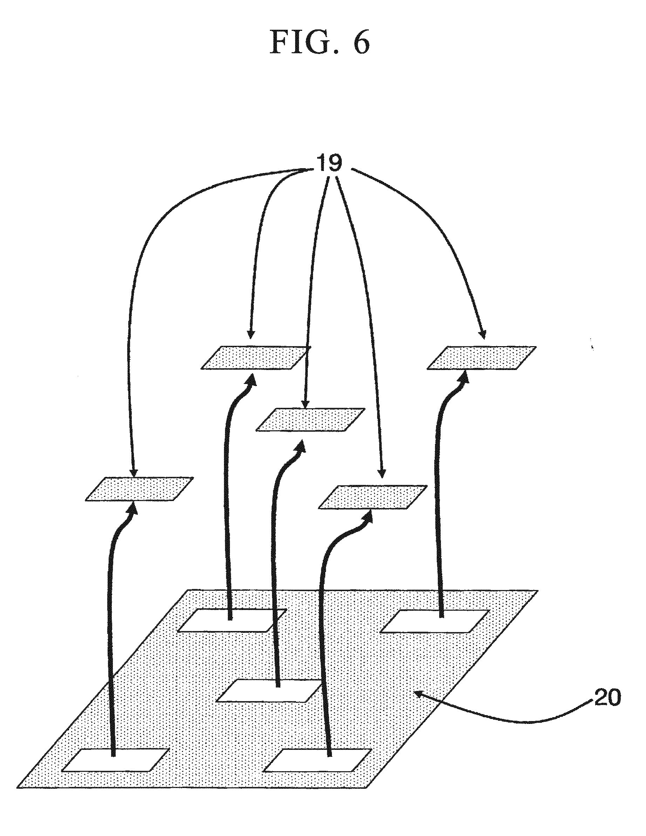

The film weight per 1 $m^2$ necessary for calculating the porosity P was calculated by weighing a film 20 of 10 cm×10 cm by the use of an electronic balance and converting the measured weight into a weight per 1 $m^2$. The maximum thickness was measured by cutting out a sample piece 19 of 1 cm×2 cm from five points of the film 20 shown in FIG. 6, immersing the sample pieces 19 in liquid nitrogen to freeze the sample pieces, cutting the sample pieces in a size of about 0.5 cm×2 cm by the use of a microtome at once, and using the resultant as a sample. By observing the cut section with the microtome through the use of an optical microscope and measuring the maximum thickness, five maximum thicknesses at five points of the film 20 were calculated and the average value of the five maximum thicknesses was employed as the maximum thickness of the film 20.

In this example, the porosity P of three points (both ends and the center) in the roll width direction, which were calculated by substituting three maximum thicknesses obtained in this way and one weight value of the film per 1 $m^2$ for the expression of the porosity defined above, was used as the porosity of the EVA resin roll.

Comparative Example 1

The bubbles of 1 $mm^2$ or more in the pseudo solar cell module were checked by using two sealing material sheets with a porosity of 7% to 9% of which both surfaces had been subjected to the embossing process as the members of the laminate and setting the other conditions to be the same as in Example 1. The results are shown in Table 1.

Comparative Example 2

The bubbles of 1 $mm^2$ or more in the pseudo solar cell module were checked by using two sealing material sheets with a porosity of 20% to 22% of which both surfaces had been subjected to the embossing process as the members of the laminate and setting the other conditions to be the same as in Example 1. The results are shown in Table 1.

Comparative Example 3

The bubbles of 1 $mm^2$ or more in the pseudo solar cell module were checked by using two sealing material sheets with a porosity of 50% to 55% of which both surfaces had been subjected to the embossing process as the members of the laminate and setting the other conditions to be the same as in Example 1. The results are shown in Table 1.

Example 2

In the pseudo solar cell module produced through the "vacuum degassing and temporary pressing process" for 60 seconds and the "main pressing process" for 10 minutes using two sealing material sheets formed by using the resin of which the minimum value of the storage elastic modulus based on the dynamic viscoelasticity measurement was 3300 Pa and performing the embossing process on both surfaces thereof so that the porosity was in the range of 3% to 4%, the bubbles of 1 $mm^2$ or more and the cell cracks were checked with visual observation.

In this example, the manufacture of the pseudo module and the checking of the bubbles and the cell cracks with visual observation were repeated 30 times. The results for the checking of the bubbles and the cell cracks visual observation are shown in Table 2.

Example 3

Under the same conditions as in Example 2, except that two sealing material sheets formed by using the resin of which the minimum value of the storage elastic modulus based on the dynamic viscoelasticity measurement was 9200 Pa and performing the embossing process on both surfaces thereof so that the porosity was in the range of 1% to 2%, the bubbles of 1 mm$^2$ or more and the cell cracks in the pseudo solar cell module were checked. The results are shown in Table 2. The results of Example 1 are also shown in Table 2.

Table 1

| | Porosity of sealing material sheet (%) | Number of instances of degassing failure for pseudo module Vacuum degassing and temporary pressing process at 150°C for 60 seconds Main pressing process at 150°C for 600 seconds | Number of instances of degassing failure for pseudo module Vacuum degassing and temporary pressing process at 150°C for 90 seconds Main pressing process at 150°C for 600 seconds |
|---|---|---|---|
| Ex. 1 | 3 to 4 | 0/30 | 0/30 |
| Com. Ex. 1 | 7 to 8 | 2/30 | 0/30 |
| Com. Ex. 2 | 20 to 21 | 2/30 | 0/30 |
| Com. Ex. 3 | 50 to 55 | 4/30 | 2/30 |

Table 2

| | Porosity of sealing material sheet (%) | Minimum value of storage elastic modulus (Pa) | Number of instances of degassing failure for pseudo module Vacuum degassing and temporary pressing process at 150°C for 90 seconds Main pressing process at 150°C for 600 seconds | |
|---|---|---|---|---|
| | | | Number of instances of degassing failure | Number of cell cracks |
| Ex. 1 | 3 to 4 | 9200 | 0/30 | 0/30 |
| Ex. 2 | 3 to 4 | 3300 | 0/30 | 0/30 |
| Ex. 3 | 1 to 2 | 9200 | 0/30 | 0/30 |

From the results of the tables, it can be seen that it is possible to reduce the amount of air infiltrated into the laminate in the step of laminating the constituent members of the solar cell module and to shorten the time necessary for the heating and degassing in a vacuum in the process of manufacturing the solar cell, by performing the embossing process on the first sealing material sheet and the second sealing material sheet so that the porosity P is in the range of 1% to 4%.

INDUSTRIAL APPLICABILITY

According to the invention, since the degassing failure in the module can be prevented and the time of the laminating process can be shortened in the solar cell module manufacturing process, it is possible to improve the production yield of the solar cell module.

DESCRIPTION OF THE REFERENCE SYMBOLS

1:      FRONT-SIDE PROTECTIVE MEMBER

2:      SEALING LAYER

3:      SOLAR CELL

4:      BACK-SIDE PROTECTIVE MEMBER

5:      FRONT-SIDE PROTECTIVE MEMBER

6:      SEALING MATERIAL SHEET

7:      SOLAR CELL

8:      SEALING MATERIAL SHEET

9:      BACK-SIDE PROTECTIVE MEMBER

10:     LAMINATING UPPER COVER

11:     BACK-SIDE PROTECTIVE MEMBER

12:     SEALING MATERIAL SHEET

13:     SOLAR CELL

14:     SEALING MATERIAL SHEET

15:     FRONT-SIDE PROTECTIVE MEMBER

16:     LAMINATING BOTTOM

17:     10 cm×10 cm EVA RESIN FILM

18:     EVA RESIN ROLL

19:     1 cm×2 cm SAMPLE PIECE FOR MEASUREMENT OF MAXIMUM THICKNESS

20:     10 cm×10 cm EVA RESIN FILM

**Claims**

**1.** A sealing material sheet which is used as a member of a solar cell module formed by heating and pressing a laminate in which a first protective member, a first sealing material sheet, a photoelectric conversion cell, a second sealing material sheet, and a second protective member are laminated in this order, comprising an uneven pattern being formed on one surface or both surfaces of the first sealing material sheet and the second sealing material sheet through an embossing process, the embossing process being performed so that the percentage $V_H/V_A \times 100$ % of the total volume $V_H$ of concave portions per unit area of the first sealing material sheet and the second sealing material sheet and the apparent volume $V_A$ of the sealing material sheets obtained by multiplying the unit area by the maximum thickness is in the range of 1% to 4%.

**2.** The sealing material sheet according to Claim 1, wherein the minimum value of a storage elastic modulus is equal to or less than $10^4$ Pa when the sealing material sheet with a thickness of 1 mm is interposed between two $\phi$25 mm A1 plates and dynamic viscoelasticity of the sealing material sheet is measured at intervals of 1°C in the course of raising the temperature from a measurement start temperature of 40°C to a measurement end temperature of 150°C with a deformation ratio of 5% and at a frequency of 1 Hz.

# FIG. 1

# FIG. 2

# FIG. 3

# FIG. 4

# FIG. 5

110cm

17

18

10cm

10cm

55cm

10cm

# FIG. 6

<table>
<tr><td colspan="2" align="center"><b>INTERNATIONAL SEARCH REPORT</b></td><td>International application No.<br>PCT/JP2010/066300</td></tr>
</table>

| A. CLASSIFICATION OF SUBJECT MATTER |
|---|
| *H01L31/042*(2006.01)i |
| According to International Patent Classification (IPC) or to both national classification and IPC |

| B. FIELDS SEARCHED |
|---|
| Minimum documentation searched (classification system followed by classification symbols)<br>H01L31/042 |
| Documentation searched other than minimum documentation to the extent that such documents are included in the fields searched<br>Jitsuyo Shinan Koho          1922-1996   Jitsuyo Shinan Toroku Koho   1996-2010<br>Kokai Jitsuyo Shinan Koho    1971-2010   Toroku Jitsuyo Shinan Koho   1994-2010 |
| Electronic data base consulted during the international search (name of data base and, where practicable, search terms used) |

| C. DOCUMENTS CONSIDERED TO BE RELEVANT | | |
|---|---|---|
| Category* | Citation of document, with indication, where appropriate, of the relevant passages | Relevant to claim No. |
| X<br>Y | WO 2001/061763 A1  (Bridgestone Corp.),<br>23 August 2001 (23.08.2001),<br>column of "Background Art"<br>& US 6660556 B2         & EP 1184912 A1 | 1<br>2 |
| Y | JP 2001-89616 A  (Du Pont-Mitsui Polychemicals<br>Co., Ltd.),<br>03 April 2001 (03.04.2001),<br>claim 3<br>(Family: none) | 2 |
| A | JP 2000-183388 A  (Bridgestone Corp.),<br>30 June 2000 (30.06.2000),<br>paragraphs [0007], [0020]<br>(Family: none) | 1-2 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>08 November, 2010 (08.11.10) | Date of mailing of the international search report<br>16 November, 2010 (16.11.10) |
|---|---|
| Name and mailing address of the ISA/<br>Japanese Patent Office | Authorized officer |
| Facsimile No. | Telephone No. |

Form PCT/ISA/210 (second sheet) (July 2009)

| INTERNATIONAL SEARCH REPORT | International application No. |
|---|---|
| | PCT/JP2010/066300 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-204074 A  (Sharp Corp.),<br>18 July 2003 (18.07.2003),<br>paragraph [0009]<br>& US 2003/0098060 A1 | 1-2 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009223906 A
- JP 3473605 B
- JP 3174531 B